(19) Europäisches Patentamt
European Patent Office
Office européen des brevets

(11) **EP 4 206 695 B1**

(12) **EUROPEAN PATENT SPECIFICATION**

(45) Date of publication and mention
of the grant of the patent:
**01.10.2025 Bulletin 2025/40**

(21) Application number: **21020659.5**

(22) Date of filing: **28.12.2021**

(51) International Patent Classification (IPC):
*G01R 27/06* (2006.01)     *G01R 27/32* (2006.01)
*G01R 29/08* (2006.01)

(52) Cooperative Patent Classification (CPC):
**G01R 27/06; G01R 27/32; G01R 29/0892**

(54) **METHODS AND SYSTEMS FOR COMPLEX RF PARAMETERS ANALYSIS IN RF AND MW ENERGY APPLICATIONS**

VERFAHREN UND SYSTEME ZUR RF-PARAMETER-ANALYSE IN RF- UND MW-ENERGIEANWENDUNGEN

MÉTHODES ET SYSTÈMES POUR L'ANALYSE DE PARAMÈTRES RF DANS LES APPLICATIONS D'ÉNERGIE RF ET MICROONDE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**05.07.2023 Bulletin 2023/27**

(73) Proprietor: **Andiva B.V.**
**6661 RG Elst (NL)**

(72) Inventor: **Pentchev, Atanas**
**6661 RG Elst (NL)**

(56) References cited:
**EP-A1- 2 648 636          WO-A1-2016/038039**
**US-A1- 2009 321 428     US-A1- 2011 168 695**
**US-A1- 2014 287 100     US-A1- 2019 069 728**

**Description**

The present disclosure describes methods for measuring and analyzing the complex parameters of multitude of RF/MW signals, occurring in various points of the energy system. The application also describes embodiments of RF and mixed-signal hardware, implementing the invented methods.

The methods deploy and process multi-tone signals in the channels of the RF/ MW energy system. The multi-tone signals consist of a high power signal, and one or multiple small-signal tones. The later ones are phase or frequency modulated with signals, either harmonic ones or signals with different waveforms), which are unique and channel-specific. The RF signals, sampled in different points of the system, could comprise the contributions of a multitude of channels. The contributions of the individual channels are differentiated, based on the applied modulation frequencies, and further analyzed, using appropriate demodulation and parameter estimation techniques. The magnitudes of the applied small-signal tones are, at least, in an order of magnitude lower than the large power ones and have insignificant impact on system's operation. Therefore, the disclosed methods can be applied both during the characterization phase of the RF/ MW energy applications, and in its "real-life" operation.

FIELD OF THE INVENTION

The present invention is concerned with the analysis of the RF parameters of solid-state radio frequency/microwave, single- and multi-channels energy systems and applications.

TECHNICAL BACKGROUND

WO2016038039A1 describes a method for controlling a cooking process of food. The method comprises the steps of obtaining a protein status in the food in the course of heating the food; determining a doneness level of the food at least partially based on the protein status; and controlling the cooking process of the food at least partially based on the determined doneness level.

US20190069728A1 describes a food system that prepares food based on a user's preferences and environment. The food system can store, cool, serve, prepare, juice, recognize with an antenna array, cut, weigh, sanitize, or compost food. The food system can include robotic arm or water jet for cutting a food item.

Radio frequency (RF) and/or microwave (MW) energy systems are widely used in a variety of consumer, professional and industrial applications: food processing, heating and drying, RF/MW plasma induced or assisted processes, chemistry and scores of others.

Recent advances of the semiconductor technologies enabled the construction of solid-state RF/MW sources capable of providing the required high levels of RF/MW energy for such applications. Contrary to the traditionally used vacuum device based sources, the solid-state ones provide efficient, accurate and flexible means for controlling the relevant signal's characteristics and process parameters:

Frequency, phase, power level and timing of the generated RF/MW power

Distribution and intensity of the electromagnetic (EM) field, applied to the processed substance, and amount of the absorbed energy

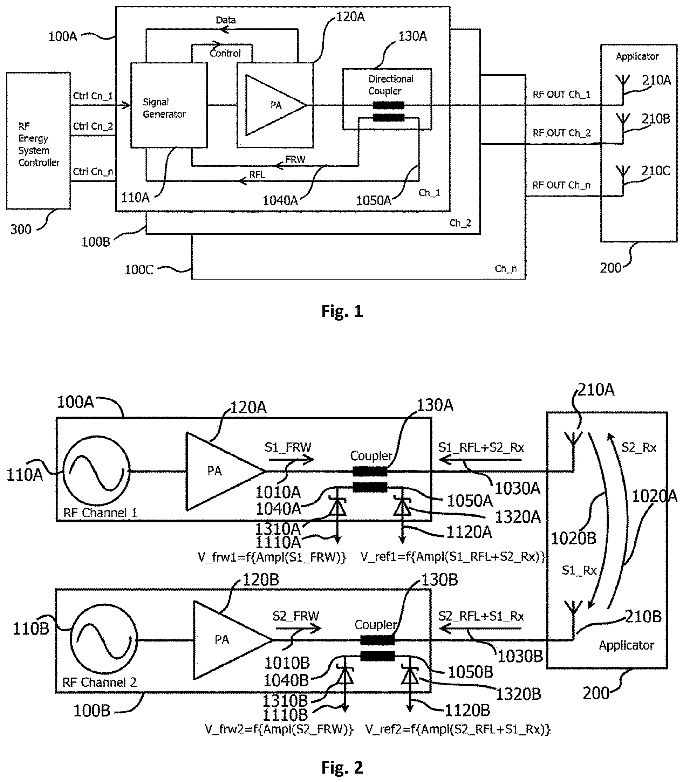

Many of the solid-state RF/MW energy systems combine the energy, generated in multiple, relatively low power sources **(Fig. 1.).**

**Fig. 1.** shows an example of a multi-channel energy system, which comprises a controller (300) which controls the three RF channels (100A, 100B and 100C). Each RF channel is constituted by three major components - a signal generator (110A), a power amplifier (120A) and a directional coupler (130A. The power of the RF channels is delivered to, and emitted in the applicator (200) by individual antennae (210A, 210B and 210C).

The power, delivered by the individual sources, could be either applied in:

common application area, where the EM fields interact

different section of the applicator, which prohibit the interferences of the EM fields

using time-multiplexing scheme, which also excludes field interferences

The case of combining coherent (phase-synchronous) signals in the applicator, and/or in front of it, appears to be of a primary interest, since it provides largest flexibility for controlling the EM field's strength and distribution inside the applicator.

In all use cases, the parameters of the RF power, generated by the individual sources, shall be controlled by algorithms, suited to the processes (heating, drying, excitation of plasma, etc.) taking place in the applicator. These algorithms may be based on one or more RF feedback signals (1040A and 1050A), sampled in different points of the system. Usually, but not exclusively, the feedback signals are sampled with directional couplers (130A) and/or circulators, which provide means for distinguishing the signals incident to the applicator from the ones traveling backward from it. The former ones, called FRW (1040A) , are samples of the signals generated by the individual RF channels in the system. The latter ones, called RFL (1050A) are signals either reflected back from the applicator (due to impedance mismatch between the individual RF channels and the load, presented at applicator's inputs ), or are signals generated by different RF channels and transmitted via the applicator to the channel, where the RFL signal is sampled.

State of the art

In order to extract information, which quantifies the performance parameters to be monitored and controlled, first the RF feedback signals should be detected. Two detection methods are commonly used:

Scalar (power or amplitude) detection

A sketch of a system using scalar detection is depicted on **Fig.2.**

**Fig. 2.** shows an example of a two-channel (100A and 100B) energy system, where the sampled by couplers (130A and 130B) feedback RF signals: FRW (1040A and 1040B) and RFL(1050A and 1050B) are detected with scalar RF (power or voltage/amplitude) detectors (1310A, 1320A, 1310B, 1320B). The resulting DC (or low-frequency) signals (1110A, 1120A, 1110B, 1120B) carry only information concerning the amplitude of the CW or amplitude modulation (envelope) of the measured signals. In case of multiple signals passing through the signal sampling point, there are no easy means* available to differentiate between the concurrent signals, which origin from the different sources employed in the system.

For instance, in the two channel system shown on the Fig.2, the detected signal V_ref1 (1120A) will be a measure of the amplitude of the sum (1030A) of S1_RFL and S2_Rx signals, where S1_RFL is the signal reflected back in channel 1 from the applicator, and S2_Rx is a portion of the signal(1020A), which has been transmitted by channel 2 and received by channel 1 via the applicator. The measured quantity is a vector sum, and is a function of the amplitude and the phase of both present signals.

*Although, in general, amplitude demodulation could separate signals, modulated with distinctive amplitude modulation schemes, such modulation techniques are hardly useable in RF/MW energy systems. Those systems must provide "maximal" energy efficiency, which is achievable only with highly saturated power amplifiers, therefore the applied amplitude modulation could be distorted (or completely lost) and the identification of the signals, originating from the different sources, would be impeded.

Vector (IQ or polar) demodulation

One or multiple vector demodulators (IQ or any other type of amplitude/phase detectors) can be used to demodulate the FRW and RFL signals.

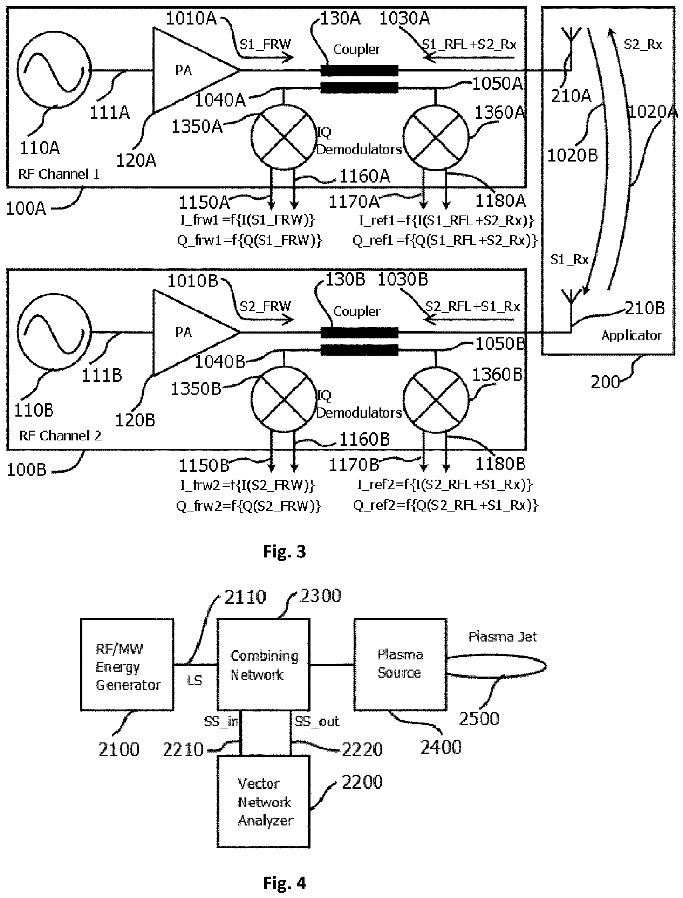

A sketch of a system using vector demodulation is depicted on **Fig.3.**

The figure shows an example of a two-channel (100A and 100B) energy system, where the sampled by couplers (130A and 130B) feedback RF signals: FRW (1040A and 1040B) and RFL (1050A, 1050B ) are detected by IQ demodulators (1350A, 1360A, 1350B and 1360B). The corresponding pairs of IQ signals I_frw1 (1150A) and Q_frw1 (1160A); I_rfl1 (1170A) and Q_rfl1 (1180A); I_frw2 (1150B) and Q_frw2 (1160B); I_rfl2 (1170B) and Q_rfl2 (1180B) are functions both of the amplitudes and of the phases of the sampled RF signals.

In the case of IQ demodulation, the amplitude and the phase (measured relative to the phase of the used reference LO, which distribution has to be precisely defined across the whole system) of the probed RF signals can be calculated using the well-known identities:

$$Ampl = \sqrt{I^2 + Q^2}$$

$$\varphi = \tan^{-1}(\frac{Q}{I})$$

where I is the in-phase and Q is the out-of-phase signal.

In a multichannel system (Fig.3), the measured amplitude (Ampl) and phase ($\phi$) quantities (respectively, I and Q in Cartesian representation) are attributes of the combined "reflected" signal - Sx_RFL+Sy_Rx (1030A, 1030B). That makes impossible to distinguish between the contribution of the individual channels: Sx_RFL and Sy_Rx. That would be possible only, if, during the measurement, the channels are time-multiplexed. That approach, however, might be suboptimal for the performance of running process.

Hot S-parameter measurement

The so-called "Hot S-parameter" measurement is an useful technique for non-invasive characterization and optimization of RF/MW energy applications.

**Fig. 4.** shows an example of a Hot S-parameters measurement setup, applied for the characterization of a plasma-jet application. A plasma source (2400) is excited by a "large signal (LS) " (2110), generated by a solid-state generator (2100).A combining network (2300) combine the large signal (2110) with the swept "small-signal (SS) " one (2210), generated by off-the-shelf vector network analyzer - VNA (2200). The combining network also delivers a sample (2220), of the combined signal (2230), reflected back from the applicator (2400). Using that signal, the VNA (2200) reconstructs the frequency response of the applicator's s-parameters (the reflection coefficient in the shown example). The power level of the small-signal's is low "enough" and doesn't affect considerably the system's operation, therefore the set-up is useful for characterization and optimization the applicator's behavior in realistic conditions. It provides for measurement of plasma-jet's reflection coefficient in a frequency range of interest, without causing substantial alteration of plasma's parameters.

The use of sophisticated and expensive T&M devices limits the usability of this implementation of the "Hot S-parameter" technique to laboratory measurement setups.

Thus, there is a need for a new method for analyzing the contributions of each channel of the (single- or multi-channel) RF/MW energy system in the RF signals (either forward, reflected or probed anywhere in the application) in a non-invasive way. Non-invasive means, that the measurement process doesn't (significantly) disturb the operational conditions of the application.

BRIEF DESCRIPTION OF THE DRAWINGS

The drawings depict some state-of-the-art RF energy systems, and exemplary, non-limiting embodiments of the invention. The description reference to the numbers in the attached figure, where same or similar elements on different figures are indicated using the same reference numbers.

The sketches are illustrative and include only details, which are of major relevance to the invention.

**Fig.** 1. shows an example of a multi-channel energy system

**Fig. 2.** shows an example of a two-channel energy system, where the sampled feedback RF signals: FRW are detected by scalar detectors

**Fig. 3.** shows an example of a two-channel energy system, where the sampled by couplers feedback RF signals are detected by IQ demodulators

**Fig. 4.** shows an example of a Hot S-parameters measurement setup, applied for the characterization of a plasma-jet application

**Fig. 5.** shows an example of the essential RF hardware, implementing the multi-tone signals, used in the disclosed measurement method

**Fig.** 6. shows first (Example 1) of the essential RF and mixed-signal hardware, implementing a two-channel RF energy system, utilizing the disclosed measurement method

**Fig. 7.** shows second example (Example 2) of the essential RF and mixed-signal hardware, implementing a two-channel RF energy system, utilizing the disclosed measurement method

**Fig. 8.** shows a typical surfaguide plasma generator, excited with MW energy provided by magnetron generator

**Fig. 9.** shows an example of a surfaguide (3400) plasma generator, excited with a pair of solid-state MW generators (3100A and 3100B)

**Fig. 10.** shows an example of a 4-channel solid-state RF/MW energy system, used in hyperthermia application

**Fig. 11.** shows an example of a plasma torch application

INVENTION DESCRIPTION

The proposed invention provides method allowing the measurement of the amplitude and the phase of any individual RF channel's contributions, probed in any arbitrary point in a single- or multi-channel RF energy systems, without significant disturbances in the processes, performed in the applicator. It is especially beneficial, but not exclusively, for RF/MW energy systems applying solid state generators.

The method is based on the generation of dual-(or multi-) tone signals in the individual RF channels. The multi-tone signals consist of:

a "main" large power [LP] signal, which might be CW, PWM-modulated, or consisting of individual or "train" of pulses

one or more lower-level, test signals [MS], which are phase (or frequency) modulated with (relatively) low-frequency, which are specific for the individual channels.

Usually, the LP signals are phase coherent, and, for the sake of processing (demodulation) convenience, the generation of the MS tones might use common clock and synchronization signals.

The multi-tone signals can be generated in many ways. IQ modulators are particularly suitable for the generation of similar signals, using multi-tone waveforms.

The modulating waveforms could be made of one, or a sum of more, harmonic signals (respectively their digital approximation), as they will be assumed for the rest of the invention disclosure. That is, however, not obligatory and different waveforms can be used, as well.

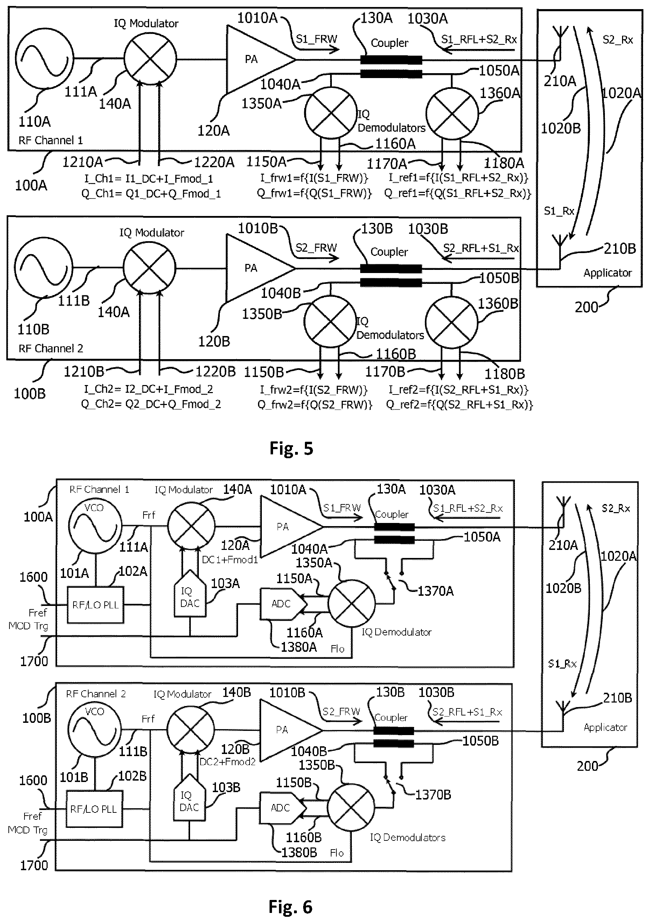

**Fig. 5.** shows an example of the essential RF hardware, implementing a two-channel (100A and 100B) RF energy system, utilizing the disclosed measurement method. The depicted embodiment uses small-signal tones which are the product of phase modulation. The two RF channels (100A and 100B) consist of transmitter and receiver paths. The coherent RF signals (111A and 111B), generated in the generators (110A and 110B) are modulated with the vector modulators (140A and 140B), using I and Q signals (1210A, 1220A; and 1210B, 1220B). The IQ signals comprise DC and AC terms. The former ones set the required phase of the large power signals, and might be also involved in setting their amplitudes (along other amplitude control devices, i.e. RF attenuators, not elaborated in the sketch). The IQ signals' AC terms, which are generated on frequencies individual for each channel, modulate the coherent RF carriers (111A and 111B), and produce, small signal tones. The modulated signals are further amplified by the power amplifiers (120A and 120B), and via the directional couplers (130A and 130B) are fed into the applicator (200). The receiver paths consist of pairs of IQ demodulators (1350A and 1360A; 1350B and 1360B), which demodulate the sampled FRW (1040A and 1040B) and RFL (1050A and 1050B) signals with LO signals, which are identical to (or at least, phase coherent with) the RF carriers (101A, 101B).

As depicted on Fig. 5, the I and Q waveforms, required for the generation of two-tone, phase modulated signal, can be calculated using the following identities:

$$I = I_{DC} + A_{MOD}\cos(2\pi F_{MOD}t),$$

and

$$Q = Q_{DC} + A_{MOD}\sin(2\pi F_{MOD}t),$$

where $I_{DC}$ and $Q_{DC}$ are DC values, ensuring the phase and the amplitude of the large-power RF tone, as required for the proper system operation (i.e. EM field distribution in case of coherent, multichannel system).

$A_{MOD}$ is the amplitude of the modulation signal, which, in order to minimize the disturbances in the performance of the RF/MW Energy system, should be relatively low,: i.e. $A_{MOD} \ll 0.1*$

$$\sqrt{Idc^2 + Qdc^2}.$$

$F_{MODx}$ are the modulation frequencies. The choice of $F_{MODx}$ is limited only by the constrains, which are imposed by the implemented phase/frequency modulation and demodulation techniques.

For instance, in case of the two-channel, coherent system, as depicted on Fig.5, the different RF signals are described with the following equations*:

$$S1\_FRW = A_{LP1}\sin(2\pi F_{RF}t + \phi_1 + A_{MOD1}\sin(2\pi F_{MOD1}t)) - \text{incident signal in Channel 1,}$$

$$S1\_RFL = S1\_FRW*S_{11} = A_{LP1}\sin(2\pi F_{RF}t + \phi_1 + A_{MOD1}\sin(2\pi F_{MOD1}t))*S_{11}$$

- reflected signal in Channel 1,

$$S2\_FRW = A_{LP2}\sin(2\pi F_{RF}t + \phi_2 + A_{MOD2}\sin(2\pi F_{MOD2}t)) - \text{incident signal in Channel 2,}$$

$$S2\_RFL = S2\_FRW*S_{22} = A_{LP2}\sin(2\pi F_{RF}t + \phi_2 + A_{MOD2}\sin(2\pi F_{MOD2}t))*S_{22}$$

- reflected signal in Channel 1,

$$S1\_Rx = S2\_FRW*S_{12} = A_{LP2}\sin(2\pi F_{RF}t + \phi_2 + A_{MOD2}\sin(2\pi F_{MOD2}t))*S_{12}$$

- the portion of the signal from Channel 2, induced to Channel 1 in the applicator,

$$S2\_Rx = S1\_FRW*S_{21} = A_{LP1}\sin(2\pi F_{RF}t + \phi_1 + A_{MOD1}\sin(2\pi F_{MOD1}t))*S_{21}$$

- the portion of the signal from Channel 1, induced to Channel 2 in the applicator Where:

$F_{RF}$ is the RF power carrier frequency (common for all channels); $A_{LP1}$ and $\phi_1$ are the amplitude and the phase of the LP$_1$ signal, generated in Ch1 ( $A_{LP1} = \sqrt{Idc1^2 + Qdc1^2}$ ; $\phi_1 = \tan^{-1}(\frac{Qdc1}{Idc1})$ )

$A_{LP2}$ and $\phi_2$ - describe LP$_2$

$A_{MOD1}$ and $F_{MOD1}$ are the amplitude and the frequency of the modulation signal - MS$_1$ (multiple modulation signals can be used, as well) applied in Ch1

$A_{MOD2}$ and $F_{MOD2}$ are the parameters of Ch2's modulation signal - MS$_2$

$S_{11}$... $S_{22}$ are the complex S-parameters, describing the 2-port (generally N-port) network of the applicator (i.e. cavity, antennas, etc.) and the feed lines, which connect it to the directional couplers.

* Unity transmitter gains (IQ modulator + PA) are assumed in the above equations.

In case, a zero-IF IQ demodulation is applied, the used $F_{LO}$ shall be coherent with $F_{RF}$. After low-pass filtering, the IQ signals measured in Ch1 could be written in the following form:

Forward path:

$$I_{FRW1} + i* Q_{FRW1} = [(I_{DC1} + i*Q_{DC1})* G_{1\_LP} + A_{MOD1}[\cos(2\pi F_{MOD1}t) + i*\sin(2\pi F_{MOD1}t)]*G_{1\_MS}]*G_{1\_RX},$$

where $G_{1\_LP}$ and $G_{1\_MS}$ are Ch1's (IQ modulator + PA) complex gain values respectively at (the actual) large power, and for small-signals. These values might diverge, depending on the PA's working condition.

$G_{1\_RX}$ is the complex gain in the receiver path of Ch1 (coupling coefficient of the directional couplers + conversion gain of the IQ demodulators), which is a either a constant, or a frequency dependent quantity, and shall be known from a preceding calibration.

Since, the FRW paths processes only signals generated in the same channel (providing high coupler/isolator directivity) the complex transmitter gains (both $G_{1\_LP}$ and $G_{1\_MS}$) could be calculated using the DC, respectively the AC components of the demodulated IQ signals.

Reflected path:

$$I_{RFL1} + i*Q_{RFL1} = \{\{(I_{DC1} + i*Q_{DC1})*G_{1\_LP} + A_{MOD1}[\cos(2\pi F_{MOD1}t) + i* \sin(2\pi F_{MOD1}t)]*G_{1\_MS}\}*S_{11} +$$
$$\{(I_{DC2} + i*Q_{DC2})* G_{2\_LP} + A_{MOD2}[\cos(2\pi F_{MOD2}t) + i*\sin(2\pi F_{MOD2}t)]*G_{2\_MS}\}*S_{12}\}*G_{1\_RX}$$

Note1: It is assumed, that the applicator's S parameters are not dependent on the signals' level (the applicator, or actually, the media processed in that doesn't possess non-linear characteristics).

Note2: zero phases of both modulation signals: $F_{MOD1}$ and $F_{MOD2}$ are assumed, because their IQ waveforms shall be synchronously generated, using the MOD Trg signal.

In this case, the amplitude and the phase of the different contributors to the RFL signals are "coded" in the low-signal tones, and can be separated and measured by the individual modulation frequencies:

$$A_{MOD1}[cos(2\pi F_{MOD1}t) + i* sin(2\pi F_{MOD1}t)]* G_{1\_MS} *S_{11}$$

term provides information exclusively for $S_{11}$, and is useful for calculating the Ch1's complex reflection coefficient

$$A_{MOD2}[cos(2\pi F_{MOD2}t) + i*sin(2\pi F_{MOD2}t)]*G_{2\_MS}*S_{12}$$

term can be used for calculation of $S_{12}$.

The parameters of the signals (amplitudes and phases), described with those two terms, can be measured after demodulating the combined reflected signal on $F_{MOD1}$, respectively $F_{MOD2}$, frequencies.

The remaining S-parameters ($S_{21}$ and $S_{22}$) can be measured and calculated in a similar way.

In case of using a low modulation frequency, it could be assumed that the calculated reflection and transmission coefficients are almost identical to the ones, presented by the applicator at the operational frequency - $F_{RF}$. Thus, they can be used for calculating the amplitude and the phase of the large power signals.

When a higher frequency modulation is applied, the measured reflection coefficient will represent the reflection value, which the channel sees at $F_{RF} \pm F_{MOD}$ frequency. Sweeping $F_{MOD}$ in $\pm\Delta f$ range, allows to measure the applicator's S-parameters in $F_{RF}\pm\Delta f$ range, which presents a feature, equivalent to the "Hot S-parameter" measurement.

The processing of the measured IQ signals (the same holds for the implementation of the LF modulation) can be done in the analog (partially) or in the digital domain. The processing steps would involve prior calibration data (i.e. directional couplers' coefficients, gains in the receiver paths, etc.), and would consist of:

Demodulate the signal of the analyzed channels (i.e., by choosing $F_{DEMODx}=F_{MODy}$)

Calculate the amplitude ($A_{DEMODx}$) and phase ($\phi_{DEMODx}$) of the demodulated $F_{DEMODx}$ signal(s)

Calculate:
Complex channel gain - $G_x$ (by using the amplitude and phase of $F_{MODx}$ signal and the ones obtained for $F_{DEMODx}$).

Complex $S_{XY}$ - the calculation is based on the previously explained identities, using the IQ parameters of $F_{MODy}$ signal ($Ch_y$ being the source channel); and the signals demodulated in the analyzed channel at $F_{DEMODy}$. Obviously, the $G_{y\_MS}$ value, already calculated in step 3.1., shall be also used as an input parameter.

The absolute amplitude levels and phases of the large-power signals (both reflected and crosscoupled between the channels), using the calculated S-parameters.

A possible embodiment of the essential HW (RF and mixed-signal) of a 2 channel system, applying the proposed IQ modulation/demodulation based measurement technique, is presented on **Fig. 6.**. The two RF channels (100A and 100B) are full-fledged - they can independently produce all required RF signals (thus, provide all RF functions required for operation as a standalone energy generator). In additions to the details, depicted on **Fig. 5.**, this figure elaborates on one possible implementation of the generators, delivering the RF carriers (111A and 111B), which are also used as LOs for the vector modulators (140A and 140B) and demodulators (1350A and 1350B). The RF carriers (111A and 111B) are generated by PLL loops consisting of VCO's (101A and 101B) and PLLs (102A and 102B). The PLLs use a common reference signal Fref (1600), which ensures the phase coherence of the generated RF carriers (111A and 111B). The IQ DACs (103A and 103B), which provide the IQ signals for the modulators (140A and 140B) use common modulation trigger signal - MOD Trg (1700) for initial phase synchronization of the synthesized IQ waveforms. The receiver paths of the RF channels (100A and 100B) time-share the vector demodulators (1350A and 1350B). The RF switches (1370A and 1370B) commutate their inputs to the FRW (1040A and 1040B) and RFL (1050A and 1050B) signals, sampled with the directional couplers (130A and 130B). The ADCs (1380A and 1380B), quantizing the demodulated IQ waveforms (1150A and 1160A, 1150B and 1160B) are also triggered by the MOD Trg signal (1700).

The architecture depicted on **Fig. 6.** is an example for Zero-IF vector ($F_{LO} = F_{RF}$) demodulation, however other alternative demodulation methods are also appropriate.

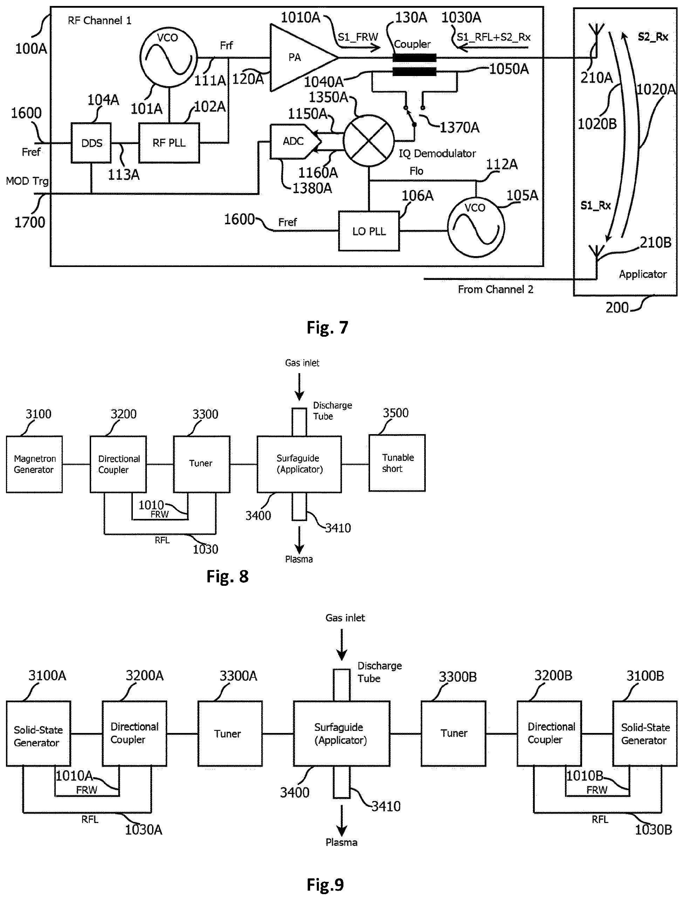

**Fig. 7.** shows an example of alternative embodiment of the transmitter and receiver tracts, which possesses larger flexibility in choosing the applied IF frequencies. The figure depicts only RF Channel 1 (100A). To a great extent, the used hardware is similar, to the one of the system from Fig. 6. The difference concerns mostly the principle, used to generate the dual tone, phase modulated RF signal (111A). Here, the small-signal, phase modulation tone(s) are imposed on the low-frequency reference signal (113A), used in by the PLL loop (101A and 102A) for generating the RF signals. The modulated reference signal (113A) is produced by a DDS (104A), capable of generating multi-tone signals. Since, the frequency of the reference signal (113A) is with few orders of magnitude lower than the one of the RF signal (111A), this approach could be better suited for generating small-signal tones, modulated with lower modulation frequencies.. Another HW difference is the second PLL loop, consisting of VCO (105A) and PPL (106A) required for synthesizing the LO signal (112A) used by the IQ demodulator (1350A). The dedicated LO PLL loop (105A and 106A) provides flexibility in choosing the IQ IF frequencies, which appears to be beneficial for handling higher modulation frequencies, useful with the "Hot S-parameters" functionality.

In the case of phase modulated small-signal tones, one of the convenient methods for evaluation of the analyzed LF IQ signals is the CFFT algorithm. It provides for the simultaneous estimation of the complex quantities of multiple signals, contributed from different RF channels.

The quantization of the obtained IQ signals shall be performed at a rate larger than twice the maximal $F_{MODx}$. It would be convenient to choose the different $F_{MODx}$ frequencies to coincide with the CFFT bins frequencies (which are a function of the chosen A/D conversion and the eventually applied down-sampling rates, and to design the $F_{MODx}$ frequency plan in a way, that the $F_{MODx}$ intermodulation products won't disturb the measurements of the analyzed small signals.

Reduced demodulation algorithms could also be used for evaluation of the individual small-signals. Two appropriate methods would be:

- IQ demodulation with local frequency $F_{LO} = F_{RF} + F_{MODx}$. In this case, the demodulated $F_{MODx}$ small-signal tone's I and Q signals will be DC ones. Thus, the only required additional signal processing step is low-pass filtering. This approach might be advantageous in case of using higher $F_{MODx}$, since the I and Q signals could be sampled at lower sampling rate.

- phase demodulation of the obtained IQ signals, which in the case of zero-IF signals($F_{LO} = F_{RF}$), could be performed by multiplying the demodulated signal with the inverse of the used small-signal modulation one.

Various frequency demodulation techniques could be used, if the small-signal tone(s) is created by applying frequency modulation.

APPLICATION EXAMPLES

The invention is beneficial for a large variety of RF/MW energy application.

Few examples:

Surfaguide MW plasma sources

A schematic representation of a typical magnetron-driven surfaguide plasma source is shown on **Fig. 8.** The plasma generator is is excited with MW energy provided by a magnetron generator (3100). The surfaguide generator consists of a waveguide applicator (3400) and a discharge tube (3410), which penetrates through the center of the applicator. The waveguide applicator (3400) has two ports. The right-hand one is loaded with a tunable short (3500), which is tuned for a maximum (E-field) of the standing wave, coinciding with the discharge tube's (3410) axis. The tuner (3200) and the directional coupler (3300) serve the impedance matching between the applicator and the magnetron generator.

This configuration is not optimal for generating plasma in the entire cross-section of the active area of the discharge tube. Due to the non-symmetric excitation, the plasma is constrained in the potion of the tube facing the magnetron.

Symmetric plasma excitation would be possible when the surfaguide is excited from both sides, with two coherent microwave generators, which provide a maximum of the delivered E-field in the center of the discharge tube. A schematic representation of similar system is shown on **Fig. 9.** The surfaguide (3400) is excited with the pair of solid-state MW generators (3100A and 3100B). The FRW (1010A and 1010B) and RFL (1030A and 1030B) signals, sampled by the directional couplers (3200A and 3200B), are used by the algorithms, controlling the parameters (amplitude and phase) of the MW generators in order to optimize the applicator's EM field distribution, and also to control the tuners (3200A and 3200B).

By applying the disclosed PM-based, multitone measurement technique is possible to achieve simultaneously a good impedance matching between the surfatron and the microwave sources, and to provide a symmetric electromagnetic field in the active zone of the discharge tube, which is a precondition for generating plasmas with higher density of the charged species.

RF/MW mediated hyperthermia

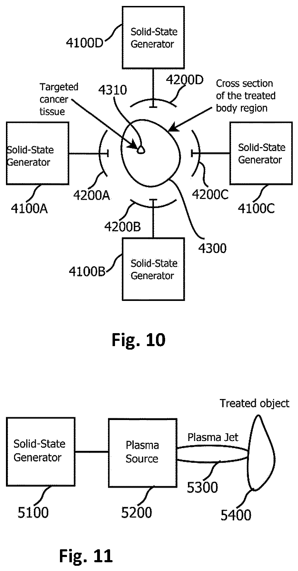

The sketch on **Fig. 10.** illustrates a schematic representation of a 4-channel solid-state RF/MW energy system applying localized heating to the targeted cancer tissue. Traditionally, these systems apply a predefined scheme for control of the amplitude/phase relations of the energy, delivered by the individual RF/MW sources, in order to achieve the aimed localized heating.

In the shows example, the solid-state generators (4100A, 4100B, 4100C and 4100D) apply their energy via 4 antennae (4200A, 4200B, 4200C and 4200D). The parameters (amplitude and phase) of all FRW and RFL signals (the signals and the sampling directional couplers are assumed to be internal to the generators, therefore are not depicted on the sketch) are constantly measured in all generators and adjusted appropriately in order to align the resulting hot-spot with the treated cancer tissue (4400).

The disclosed invention provides means for continuous measurement of the multiport S-parameter matrix and adjustments of the amplitude/phase settings of all sources, without causing process disruptions, thus enhancing the treatment efficiency and reducing the risks for unwanted heating of organs/tissues in the neighboring areas.

Plasma torch applications

Some plasma sources generate plasmas, which interacts with the treated matter in the plasma active zone, or in its vicinity. That interaction might change the operational conditions of the plasma source.

**Fig. 11.** shows an example of a plasma torch application. The solid-state generator (5100) excites the plasma in the plasma source (5200). The plasma column (5300) extends outside the torch and interacts with the treated object (5400). The generator constantly measures the frequency response of the plasma source's reflection coefficient and tunes the frequency of the applied RF/MW energy for minimal reflection.

The proposed invention, enables continuous and non-invasive measurements of the plasma source input impedance and its frequency response (i.e., by applying the so called Hot-S parameter measurement).

The measured quantities could be used for tuning the RF/MW signal frequency for obtaining a minimal reflection from the plasma source. If a tuner is used for "external" impedance matching, the measured data could be also used in the algorithm(s), governing the dynamic impedance matching.

Note: The described method for measurement of the applicator's impedance/reflection coefficient is applicable in any RF/MW Energy application, which would benefits from a non-invasive, in-process monitoring and control, especially in cases, when the applicator's frequency response possesses strong resonance characteristics, or multiple minima's.

**Claims**

1. A method of characterizing a radio frequency (RF) or microwave (MW) energy system comprising multiple RF channels (100A, 100B) and an applicator (200), wherein one or more RF source signals are applied to one or more RF channels for providing RF energy to the applicator, the method comprising:

   - generating for the one or more RF channels a multi-tone signal by modulating in phase or frequency a RF carrier signal (111A, 111B) at a carrier frequency with one or more modulating signals, wherein the one or more modulating signals have amplitudes ($A_{MOD1}$, $A_{MOD2}$) at least in an order of magnitude lower than the amplitude of the RF carrier signal and predetermined modulation frequencies ($F_{MOD1}$, $F_{MOD2}$) for one or more RF channels (100A, 100B),
   - applying the generated multi-tone signal to at least one of the one or more RF channels,
   - sampling, in a forward signal path of at least one of the multiple RF channel directed from the RF channel to the applicator, an RF signal (1040A, 1040B) incident on the applicator (200), and sampling, in a reflected signal path of the same or different RF channel directed from the applicator to the same or different RF channel, an RF signal (1050A, 1050B) reflected from the applicator (200),
   - demodulating at the carrier frequency, the sampled RF signal (1040A, 1040B) incident on the applicator and the sampled RF signal (1050A, 1050B) reflected from the applicator, to obtain a demodulated forward signal (1150A, 1160A, 1150B, 1160B) and a demodulated reflected signal (1170A, 1180A, 1170B, 1180B), respectively,
   - selecting, in the demodulated forward signal and the demodulated reflected signal, the small signal tones at the predetermined modulation frequencies of an RF channel to be analyzed and measuring the amplitudes and phases of such small signal tones,
- calculating, using the measured amplitudes and phases of the small-signal tones, the complex transmission and reflection coefficients for the RF channel to be analyzed.

2. The method of claim 1, wherein the predetermined modulation frequency (Fref) is a few order of magnitudes lower than the carrier frequency (Frf).

3. The method of claim 1 or claim 2, wherein the predetermined modulation frequency for an RF channels is swept within a predetermined range.

4. The method of any of the previous claims, wherein all RF carrier signals of all RF channels are coherent.

5. The method of claim 4, wherein generating the multi-tone signal comprises using a phase locked loop which uses a first reference signal common to the multiple RF channels for generating the RF carrier signal.

6. The method of any of the previous claims, wherein generating the multi-tone signal involves IQ modulation of the RF carrier signal which is provided as reference local oscillator signal for the IQ modulation.

7. The method of any of the previous claims, wherein generating the unique multi-tone signal comprises generating the IQ waveforms of the modulating signals by an IQ digital to analog converters using a common trigger signal for the synchronization of the phase of the modulating signals of the multiple RF channels.

8. The method of any of the claims 1 to 4, wherein generating the unique multi-tone signal comprises using a Direct Digital synthesizer (DDS) and a phase locked loop (PLL) for generating the multi-tone signal, wherein a second reference signal (Fref) common to the multiple RF channels is inputted to the Direct Digital synthesizer which outputs a third reference signal (113A) to the phase locked loop.

9. The method of any of the previous claims, wherein demodulating at the carrier frequency the sampled incident and reflected RF signals comprises

- IQ demodulation (1350A, 1350B) of the sampled RF signal (1040A, 1040B) incident on the applicator and the sampled RF signal (1050A, 1050B) reflected from the applicator to obtain an IQ demodulated forward signal (1150A, 1160A, 1150B, 1160B) and an IQ demodulated reflected signal (1150A, 1160A, 1150B, 1160B), respectively, and
- quantizing the IQ demodulated forward and reflected signals by an analog to digital converter (1380A, 1380B) which uses a trigger signal (MOD Trg) for the demodulation.

10. The method of any of the previous claims, wherein demodulating at the carrier frequency the sampled RF signal incident on the applicator and the sampled RF signal reflected from the applicator, comprises using an RF switch (1370A, 1370B) to switch between the sampled RF signal incident on the applicator and the sampled RF signal reflected from the applicator.

11. A radio frequency (RF) or microwave (MW) energy system comprises

- multiple RF channels (100A, 100B),
- an applicator (200), and
- a probing device (130A, 130 B) configured to

sample, in a forward signal path directed from at least one RF channel to the applicator, an RF signal incident on the applicator (200), and
sample, in a reflected signal path of the same or different RF channel directed from the applicator to the same or different RF channel, an RF signal reflected from the applicator (200), and

wherein one or more of the multiple RF channels comprise:

- one ore more RF source signal generators (110A, 110B, 101A, 101B) for providing RF energy to the applicator (200),

- a modulator (140A, 140B) configured to generate a multi-tone signal by modulating in phase or frequency a RF carrier signal (111A, 111B) at a carrier frequency with one or more modulating signals, wherein the one or more modulating signals have amplitudes ($A_{MOD1}$, $A_{MOD2}$) at least in an order of magnitude lower than the amplitude of the RF carrier signal and predetermined modulation frequencies ($F_{MOD1}$, $F_{MOD2}$) for one or more RF channels (100A, 100B),

- a demodulator (1350 A, 1350B) configured to demodulate at the carrier frequency, the sampled RF signal (1040A, 1040B) incident on the applicator and the sampled RF signal (1050A, 1050B) reflected from the applicator, to obtain a demodulated forward signal (1150A, 1160A, 1150B, 1160B) and a demodulated reflected signal (1170A, 1180A, 1170B, 1180B), respectively,

- a calculator configured to calculate the complex transmission and reflection coefficients for RF channel to be analyzed, using measured amplitudes and phases of small signal tones in the demodulated forward signal (1150A, 1160A, 1150B, 1160B) and the demodulated reflected signal (1170A, 1180A, 1170B, 1180B) at the predetermined modulation frequencies of an RF channel to be analyzed.

12. The system of claim 11, wherein the applicator is a surfaguide plasma source consisting of a waveguide applicator (3400) and a discharge tube (3410), or a body with a targeted cancer tissue (4310), or a plasma torch producing a plasma jet (5300) for treating an object (5400).

13. The system of claim 11 or 12, further comprising an adjusting device, and wherein the adjusting device is configured to adjust the amplitudes and phase of the one or more RF source signal generators in response to continuously measured amplitudes and phase of the small signal tones for controlling the energy delivered to the applicator and/or for controlling the impedance of the applicator.

**Patentansprüche**

1. Ein Verfahren zur Charakterisierung eines Hochfrequenz- (HF) oder Mikrowellen- (MW) Energiesystems, das mehrere HF-Kanäle (100A, 100B) und einen Applikator (200) umfasst, wobei ein oder mehrere HF-Quellensignale an einen oder mehrere HF-Kanäle angelegt werden, um dem Applikator HF-Energie zuzuführen, wobei das Verfahren umfasst:

- Erzeugen eines Mehrtonsignals für den einen oder die mehreren HF-Kanäle durch Phasen- oder Frequenzmodulation eines HF-Trägersignals (111A, 111B) bei einer Trägerfrequenz mit einem oder mehreren Modulationssignalen, wobei das eine oder die mehreren Modulationssignale Amplituden ($A_{MOD1}$, $A_{MO02}$) aufweisen, die mindestens eine Größenordnung niedriger sind als die Amplitude des HF-Trägersignals, sowie vorbestimmte Modulationsfrequenzen ($F_{M0D1}$, $F_{M0D2}$) für einen oder mehrere HF-Kanäle (100A, 100B),

- Anlegen des erzeugten Mehrtonsignals an mindestens einen des einen oder der mehreren HF-Kanäle,

- Abtasten, in einem Vorwärtssignalpfad von mindestens einem der mehreren HF-Kanäle, der vom HF-Kanal zum Applikator gerichtet ist, eines auf den Applikator (200) einfallenden HF-Signals (1040A, 1040B), und Abtasten, in einem reflektierten Signalpfad desselben oder eines anderen HF-Kanals, der vom Applikator zu demselben oder einem anderen HF-Kanal gerichtet ist, eines vom Applikator (200) reflektierten HF-Signals (1050A, 1050B),

- Demodulieren des abgetasteten, auf den Applikator einfallenden HF-Signals (1040A, 1040B) und des abgetasteten, vom Applikator reflektierten HF-Signals (1050A, 1050B) bei der Trägerfrequenz, um ein demoduliertes Vorwärtssignal (1150A, 1160A, 1150B, 1160B) bzw. ein demoduliertes reflektiertes Signal (1170A, 1180A, 1170B, 1180B) zu erhalten,

- Auswählen, im demodulierten Vorwärtssignal und im demodulierten reflektierten Signal, der Kleinsignaltöne bei den vorbestimmten Modulationsfrequenzen eines zu analysierenden HF-Kanals und Messen der Amplituden und Phasen solcher Kleinsignaltöne,

- Berechnen, unter Verwendung der gemessenen Amplituden und Phasen der Kleinsignaltöne, der komplexen Transmissions- und Reflexionskoeffizienten für den zu analysierenden HF-Kanal.

2. Das Verfahren nach Anspruch 1, wobei die vorbestimmte Modulationsfrequenz (Fref) einige Größenordnungen niedriger ist als die Trägerfrequenz (Frf).

3. Das Verfahren nach Anspruch 1 oder Anspruch 2, wobei die vorbestimmte Modulationsfrequenz für einen HF-Kanal innerhalb eines vorbestimmten Bereichs durchlaufen wird.

4. Das Verfahren nach einem der vorhergehenden Ansprüche, wobei alle HF-Trägersignale aller HF-Kanäle kohärent sind.

5. Das Verfahren nach Anspruch 4, wobei das Erzeugen des Mehrtonsignals die Verwendung eines Phasenregelkreises (Phase Locked Loop, PLL) umfasst, der ein erstes, den mehreren HF-Kanälen gemeinsames Referenzsignal zum Erzeugen des HF-Trägersignals verwendet.

6. Das Verfahren nach einem der vorhergehenden Ansprüche, wobei das Erzeugen des Mehrtonsignals eine IQ-Modulation des HF-Trägersignals beinhaltet, das als Referenz-Lokaloszillatorsignal für die IQ-Modulation bereitgestellt wird.

7. Das Verfahren nach einem der vorhergehenden Ansprüche, wobei das Erzeugen des einzigartigen Mehrtonsignals das Erzeugen der IQ-Wellenformen der Modulationssignale durch IQ-Digital-Analog-Wandler umfasst, unter Verwendung eines gemeinsamen Triggersignals zur Synchronisation der Phase der Modulationssignale der mehreren HF-Kanäle.

8. Das Verfahren nach einem der Ansprüche 1 bis 4, wobei das Erzeugen des einzigartigen Mehrtonsignals die Verwendung eines direkten digitalen Synthesizers (Direct Digital Synthesizer, DDS) und eines Phasenregelkreises (Phase Locked Loop, PLL) zum Erzeugen des Mehrtonsignals umfasst, wobei ein zweites, den mehreren HF-Kanälen gemeinsames Referenzsignal (Fref) in den direkten digitalen Synthesizer eingespeist wird, der ein drittes Referenzsignal (113A) an den Phasenregelkreis ausgibt.

9. Das Verfahren nach einem der vorhergehenden Ansprüche, wobei das Demodulieren der abgetasteten einfallenden und reflektierten HF-Signale bei der Trägerfrequenz umfasst:

- IQ-Demodulation (1350A, 1350B) des abgetasteten, auf den Applikator einfallenden HF-Signals (1040A, 1040B) und des abgetasteten, vom Applikator reflektierten HF-Signals (1050A, 1050B), um ein IQ-demoduliertes Vorwärtssignal (1150A, 1160A, 1150B, 1160B) bzw. ein IQ-demoduliertes reflektiertes Signal (1150A, 1160A, 1150B, 1160B) zu erhalten, und
- Quantisieren der IQ-demodulierten Vorwärts- und reflektierten Signale durch einen Analog-Digital-Wandler (1380A, 1380B), der ein Triggersignal (MOD Trg) für die Demodulation verwendet.

10. Das Verfahren nach einem der vorhergehenden Ansprüche, wobei das Demodulieren des abgetasteten, auf den Applikator einfallenden HF-Signals und des abgetasteten, vom Applikator reflektierten HF-Signals bei der Trägerfrequenz die Verwendung eines HF-Schalters (1370A, 1370B) umfasst, um zwischen dem abgetasteten, auf den Applikator einfallenden HF-Signal und dem abgetasteten, vom Applikator reflektierten HF-Signal umzuschalten.

11. Ein Hochfrequenz- (HF) oder Mikrowellen- (MW) Energiesystem, umfassend:

- mehrere HF-Kanäle (100A, 100B),
- einen Applikator (200), und
- eine Sondierungsvorrichtung (130A, 130B), die konfiguriert ist, um

in einem Vorwärtssignalpfad, der von mindestens einem HF-Kanal zum Applikator gerichtet ist, ein auf den Applikator (200) einfallendes HF-Signal abzutasten, und
in einem reflektierten Signalpfad desselben oder eines anderen HF-Kanals, der vom Applikator zu demselben oder einem anderen HF-Kanal gerichtet ist, ein vom Applikator (200) reflektiertes HF-Signal abzutasten, und

wobei einer oder mehrere der mehreren HF-Kanäle umfassen:

- einen oder mehrere HF-Quellensignalgeneratoren (110A, 110B, 101A, 101B) zur Zuführung von HF-Energie zum Applikator (200),
- einen Modulator (140A, 140B), der konfiguriert ist, um ein Mehrtonsignal durch Phasen- oder Frequenzmodulation eines HF-Trägersignals (111A, 111B) bei einer Trägerfrequenz mit einem oder mehreren Modulationssignalen zu erzeugen, wobei das eine oder die mehreren Modulationssignale Amplituden ($A_{MOD1}$, $A_{MOD2}$) aufweisen, die mindestens eine Größenordnung niedriger sind als die Amplitude des HF-Trägersignals, sowie vorbestimmte Modulationsfrequenzen ($F_{M0D1}$, $F_{M0D2}$) für einen oder mehrere HF-Kanäle (100A, 100B),
- einen Demodulator (1350A, 1350B), der konfiguriert ist, um das abgetastete, auf den Applikator einfallende HF-Signal (1040A, 1040B) und das abgetastete, vom Applikator reflektierte HF-Signal (1050A, 1050B) bei der Trägerfrequenz zu demodulieren, um ein demoduliertes Vorwärtssignal (1150A, 1160A, 1150B, 1160B) bzw. ein demoduliertes reflektiertes Signal (1170A, 1180A, 1170B, 1180B) zu erhalten,

- eine Recheneinheit, die konfiguriert ist, um die komplexen Transmissions- und Reflexionskoeffizienten für einen zu analysierenden HF-Kanal zu berechnen, unter Verwendung von gemessenen Amplituden und Phasen von Kleinsignaltönen im demodulierten Vorwärtssignal (1150A, 1160A, 1150B, 1160B) und im demodulierten reflektierten Signal (1170A, 1180A, 1170B, 1180B) bei den vorbestimmten Modulationsfrequenzen eines zu analysierenden HF-Kanals.

12. Das System nach Anspruch 11, wobei der Applikator eine Surfaguide-Plasmaquelle ist, die aus einem Hohlleiterapplikator (3400) und einem Entladungsrohr (3410) besteht, oder ein Körper mit einem anvisierten Krebsgewebe (4310), oder ein Plasmabrenner, der einen Plasmastrahl (5300) zur Behandlung eines Objekts (5400) erzeugt.

13. Das System nach Anspruch 11 oder 12, ferner umfassend eine Einstellvorrichtung, und wobei die Einstellvorrichtung konfiguriert ist, um die Amplituden und die Phase des einen oder der mehreren HF-Quellensignalgeneratoren in Reaktion auf kontinuierlich gemessene Amplituden und Phasen der Kleinsignaltöne anzupassen, zur Steuerung der an den Applikator abgegebenen Energie und/oder zur Steuerung der Impedanz des Applikators.

**Revendications**

1. Procédé de caractérisation d'un système d'énergie à radiofréquences (RF) ou à micro-ondes (MW) comprenant plusieurs canaux RF (100A, 100B) et un applicateur (200), dans lequel un ou plusieurs signaux de source RF sont appliqués à un ou plusieurs canaux RF pour fournir de l'énergie RF à l'applicateur, le procédé comprenant:

- la génération, pour le ou les canaux RF, d'un signal multitonal en modulant en phase ou en fréquence un signal porteur RF (111A, 111B) à une fréquence porteuse avec un ou plusieurs signaux de modulation, dans lequel le ou les signaux de modulation des amplitudes ($A_{MOD1}$, $A_{MOD2}$) au moins d'un ordre de grandeur inférieur à l'amplitude du signal porteur RF et des fréquences de modulation prédéterminées ($F_{MOD1}$, $F_{MOD2}$) pour un ou plusieurs canaux RF (100A, 100B),
- l'application du signal multitonal généré à au moins l'un des canaux RF,
- l'échantillonnage, dans un trajet de signal direct d'au moins l'un des multiples canaux RF dirigé du canal RF vers l'applicateur, d'un signal RF (1040A, 1040B) incident sur l'applicateur (200), et l'échantillonnage, dans un trajet de signal réfléchi du même canal RF ou d'un canal RF différent dirigé de l'applicateur vers le même canal RF ou un canal RF différent, d'un signal RF (1050A, 1050B) réfléchi par l'applicateur (200),
- la démodulation, à la fréquence porteuse, du signal RF échantillonné (1040A, 1040B) incident sur l'applicateur et du signal RF échantillonné {1050A, 1050B} réfléchis par l'applicateur, afin d'obtenir un signal direct démodulé (1150A, 1160A, 1150B, 1160B) et un signal réfléchi démodulé (1170A, 1180A, 1170B, 1180B), respectivement,
- la sélection, dans le signal direct démodulé et le signal réfléchi démodulé, des petites tonalités de signal aux fréquences de modulation prédéterminées d'un canal RF à analyser et la mesure des amplitudes et des phases de ces petites tonalités de signal,
- le calcul, à l'aide des amplitudes et des phases mesurées des petites tonalités de signal, des coefficients de transmission et de réflexion complexes pour le canal RF à analyser.

2. Procédé selon l'indication 1, dans lequel la fréquence de modulation prédéterminée (Fref) est inférieure de plusieurs ordres de grandeur à la fréquence porteuse (Frf).

3. Procédé selon l'indication 1 ou 2, dans lequel la fréquence de modulation prédéterminée pour un canal RF est balayée dans une plage prédéterminée.

4. Procédé selon l'une quelconque des indications précédentes, dans lequel tous les signaux porteurs RF de tous les canaux RF sont cohérents.

5. Procédé selon l'indication 4, dans lequel la génération du signal multitonal comprend l'utilisation d'une boucle à verrouillage de phase qui utilise un premier signal de référence commun aux multiples canaux RF pour générer le signal porteur RF.

6. Procédé selon l'une des indications précédentes, dans lequel la génération du signal multitonal implique une modulation IQ du signal porteur RF qui est fourni comme signal d'oscillateur local de référence pour la modulation IQ.

7. Procédé selon l'une des indications précédentes, dans lequel la génération du signal multitonal unique comprend la génération des formes d'onde IQ des signaux de modulation par des convertisseurs numériques-analogiques IQ utilisant un signal de déclenchement commun pour la synchronisation de la phase des signaux de modulation des multiples canaux RF.

8. Procédé selon l'une des indications 1 à 4, dans lequel la génération du signal multitonal unique comprend l'utilisation d'un synthétiseur numérique direct (DDS) et d'une boucle à verrouillage de phase (PLL) pour générer le signal multitonal, dans lequel un deuxième signal de référence (Fref) commun aux multiples canaux RF est transmis au synthétiseur numérique direct qui génère un troisième signal de référence (113A) à la boucle à verrouillage de phase.

9. Procédé selon l'une des indications précédentes, dans lequel la démodulation à la fréquence porteuse des signaux RF incidents et réfléchis échantillonnés comprend

- la démodulation IQ (1350A, 1350B) du signal RF échantillonné (1040A, 1040B) incident sur l'applicateur et du signal RF échantillonné (1050A, 1050B) réfléchis par l'applicateur afin d'obtenir un signal direct IQ démodulé (1150A, 1160A, 1150B, 1160B) et un signal réfléchi IQ démodulé (1150A, 1160A, 1150B, 1160B), respectivement, et
- la quantification des signaux avant et réfléchi démodulés IQ par un convertisseur analogique-numérique (1380A, 1380B) qui utilise un signal de déclenchement (MOD Trg) pour la démodulation.

10. Procédé selon l'une des indications précédentes, dans lequel la démodulation à la fréquence porteuse du signal RF échantillonné incident sur l'applicateur et du signal RF échantillonné réfléchi par l'applicateur comprend l'utilisation d'un commutateur RF (1370A, 1370B) pour commuter entre le signal RF échantillonné incident sur l'applicateur et le signal RF échantillonné réfléchi par l'applicateur.

11. Un système d'énergie radiofréquence (RF) ou micro-ondes (MW) comprend

- plusieurs canaux RF (100A, 100B),
- un applicateur (200), et
- un dispositif de sondage (130A, 130B) configuré pour

échantillonner, dans un trajet de signal direct depuis au moins un canal RF vers l'applicateur, un signal RF incident sur l'applicateur (200), et
pour échantillonner, dans un trajet de signal réfléchi du même canal RF ou d'un canal RF différent depuis l'applicateur vers le même canal RF ou un canal RF différent, un signal RF réfléchi depuis l'applicateur (200), et

dans lequel un ou plusieurs des multiples canaux RF comprennent:

- un ou plusieurs générateurs de signaux de source RF (110A, 110B, 101A, 101B) pour fournir de l'énergie RF à l'applicateur (200),
- un modulateur (140A, 140B) configuré pour générer un signal multitonal en modulant en phase ou en fréquence un signal porteur RF (111A, 111B) à une fréquence porteuse avec un ou plusieurs signaux de modulation, dans lequel le ou les signaux de modulation ont des amplitudes ($A_{MOD1}$, $A_{MOD2}$) au moins d'un ordre de grandeur inférieur l'amplitude du signal porteur RF et des fréquences de modulation predetermines ($F_{MOD1}$, $F_{MOD2}$) pour un ou plusieurs canaux RF (100A, 100B),
- un démodulateur (1350A, 1350B) configuré pour démoduler à la fréquence porteuse, le signal RF échantillonné (1040A, 1040B) incident sur l'applicateur et le signal RF échantillonné (1050A, 1050B) réfléchis par l'applicateur, afin d'obtenir un signal direct démodulé (1150A, 1160A, 1150B, 1160B) et un signal réfléchi démodulé (1170A, 1180A, 1170B, 1180B), respectivement,
- un calculateur configuré pour calculer les coefficients de transmission et de réflexion complexes pour le canal RF à analyser, en utilisant les amplitudes et les phases mesurées des petites tonalités de signal dans le signal direct démodulé (1150A, 1160A, 1150B, 1160B) et du signal réfléchi démodulé (1170A, 1180A, 1170B, 1180B) aux fréquences de modulation prédéterminées d'un canal RF à analyser.

12. Système selon l'indication 11, dans lequel l'applicateur est une source de plasma à guidage de surface composée d'un applicateur à guide d'ondes (3400) et d'un tube à décharge (3410), ou d'un corps avec un tissu cancéreux ciblé (4310), ou d'une torche à plasma produisant un jet de plasma (5300) pour traiter un objet (5400).

13. Système selon l'indication 11 ou 12, comprenant en outre un dispositif de réglage, et dans lequel le dispositif de réglage est configuré pour régler les amplitudes et la phase d'un ou plusieurs générateurs de signaux RF en réponse aux amplitudes et à la phase mesurées en continu des tonalités faibles afin de contrôler l'énergie fournie à l'applicateur et/ou de contrôler l'impédance de l'applicateur.

**Fig. 1**

**Fig. 2**

**Fig. 3**

**Fig. 4**

**Fig. 5**

**Fig. 6**

EP 4 206 695 B1

**Fig. 7**

**Fig. 8**

**Fig.9**

**Fig. 10**

**Fig. 11**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2016038039 A1
- US 20190069728 A1